# EUROPÄISCHE PATENTSCHRIFT

(11) **EP 3 870 979 B1**
(45) Veröffentlichungstag und Bekanntmachung des Hinweises auf die Patenterteilung: **07.09.2022**
(21) Anmeldenummer: 19795524.8
(22) Anmeldetag: 24.10.2019
(51) Int. Cl.: G01R 1/067

(54) **EINPOLIGER PRÜFSTIFT**
SINGLE-POLE TEST PIN
BROCHE D'ESSAI UNIPOLAIRE

(30) Priorität: 26.10.2018 DE 202018106154 U
(43) Veröffentlichungstag der Anmeldung: 01.09.2021
(73) Patentinhaber: Feinmetall GmbH, 71083 Herrenberg (DE)
(72) Erfinder: GAUSS, Lorenz, 71083 Herrenberg (DE); FLIK, Mark, 71083 Herrenberg (DE); BURGOLD, Jörg, 71083 Herrenberg (DE); GÜNTHER, Verena, 70563 Stuttgart (DE)
(74) Vertreter: Clarenbach, Carl-Philipp
(86) Internationale Anmeldenummer: PCT/EP2019/079114
(87) Internationale Veröffentlichungsnummer: WO 2020/084098

(56) Entgegenhaltungen:
- WO-A1-2006/025510
- DE-U1- 20 315 894
- DE-U1-202010 007 227

## Beschreibung

Die Erfindung betrifft einen einpoligen Prüfstift zum lösbaren Kontaktieren eines elektrisch leitfähigen und stiftförmig ausgebildeten Kontaktpartners, mit einem in einer Führungshülse längsverschieblich lagerbaren oder gelagerten Kolben, der an einem freien Ende Mittel zum elektrisch leitenden Berührungskontaktieren des Kontaktpartners aufweist.

Aus dem Stand der Technik sind Prüfstifte zum lösbaren Kontaktieren eines Kontaktpartners bekannt. Für die Durchführung elektrischer Prüfungen werden häufig elektrische Anschlusskontakte von Prüflingen berührungskontaktiert, um die Anschlusskontakte beispielsweise mit einer elektrischen Spannung zu beaufschlagen, beispielsweise um die Funktion des Prüflings zu testen. Zur Berührungskontaktierung ist es bekannt, Prüfstifte, insbesondere Federkontaktstifte, zu verwenden, die auf dem Anschlusskontakt aufsetzen und optional in ihrer Längserstreckung zurückfedern können, um eine Beschädigung des Prüflings zu vermeiden. Handelt es sich bei dem Anschlusskontakt um ein Kontaktplättchen oder eine Lötstelle oder dergleichen, so weist der Prüfstift vorzugsweise eine Kontaktspitze auf, um die Kontaktstelle zu berühren. Bei Kontaktpartnern eines Prüflings, die jedoch stiftförmig ausgebildet sind, ist teilweise vorgesehen, diese nicht an ihrem freien Stirnende, sondern an ihrer Mantelaußenfläche, also umfangsseitig zu kontaktieren, um beispielsweise eine großflächige Berührungskontaktierung zu erreichen, durch welche ein hoher Stromfluss ermöglicht ist. Bekannte Prüfstifte weisen dazu einen Kolben auf, der optional in einer Führungshülse längsverschieblich gelagert ist, um beispielsweise in seiner Längserstreckung zurückfedern zu können, und an einem freien Ende Mittel zum elektrischen Berührungskontaktieren des Kontaktpartners aufweist. Dabei kann es sich beispielsweise um Federelemente handeln, die von dem freien Ende vorstehen und zwischen sich den Kontaktpartner aufnehmen. Unter einem einpoligen beziehungsweise einkanaligen Prüfstift ist dabei ein Prüfstift zu versehen, der nur eine einzige elektrische Verbindung von dem Kontaktpartner zu einer Prüfeinrichtung herstellt. Der einpolige Kontaktstift weist somit nur einen einzigen elektrischen Leitungsweg auf.

Aus der Offenlegungsschrift WO 2006/025510 A1 ist bereits ein einpoliger Prüfstift bekannt, der einen Kolben aufweist, der in einer Führungshülse gelagert ist, sowie eine Schraubenfeder, durch welche der Kolben radial gegen die Innenseite der Führungshülse gepresst wird. Auch aus der Offenlegungsschrift DE 203 15 894 U1 ist bereits ein einpoliger Prüfstift bekannt. Aus der Offenlegungsschrift DE 20 2010 007227 U1 ist ein zweipoliger Prüfstift bekannt.

Der Erfindung liegt die Aufgabe zugrunde, einen einpoligen Prüfstift zu schaffen, der zur beschädigungsarmen oder freien Berührungskontaktierung eines stiftförmigen Kontaktpartners geeignet ist und eine Vielzahl von Kontaktierungsvorgängen ermöglicht, ohne dass der jeweilige Kontaktpartner oder Prüfstift selbst schnell verschleißt.

Die der Erfindung zugrundeliegende Aufgabe wird durch den einpoligen Prüfstift mit den Merkmalen des Anspruchs 1 gelöst. Dieser hat den Vorteil, dass die Kontaktierungsmittel einfach und sicher an dem Kolben angeordnet und dadurch gleichzeitig vorteilhaft an dem Kolben geführt/gehalten sind, um eine Beschädigung des Kontaktpartners und/oder der Kontaktmittel selbst zu reduzieren oder zu vermeiden.

Erfindungsgemäß ist hierzu vorgesehen, dass eine Mantelwand des elektrisch leitfähig ausgebildeten Kolbens an seinem freien Ende zumindest eine Radialvertiefung aufweist, in welcher zumindest eine Schraubenfeder angeordnet ist, die sich quer zur Längserstreckung des Kolbens erstreckt und radial von der Mantelwand vorsteht. Die Schraubenfeder weist somit als Mittel für den elektrisch leitenden Berührungskontakt einen Durchmesser auf, der größer ist als die Tiefe der Radialvertiefung, sodass die Schraubenfeder von der Mantelwand vorsteht. Durch die Anordnung in der Radialvertiefung ist sie in axialer Richtung vorteilhaft an dem Kolben gestützt. Vorzugsweise weist die Radialvertiefung dazu eine Breite auf, in Axialerstreckung des Kolbens gesehen, die nicht oder nur geringfügig größer ist als die Breite der Schraubenfeder selbst, sodass die Schraubenfeder axial zumindest im Wesentlichen formschlüssig in der Radialvertiefung gehalten ist. Durch ihre elastische Verformbarkeit ist die Schraubenfeder radial verformbar oder verschiebbar, sodass beim Kontaktieren des Kontaktpartners eine Vorspannung durch das elastische Verformen der Schraubenfeder entsteht, welche einen sicheren Anlagekontakt der Schraubenfeder an dem Kontaktpartner zur dauerhaft sicheren Berührungskontaktierung gewährleistet. Bei der Schraubenfeder handelt es sich bevorzugt um einen Metalldraht als Grundelement, das schraubenförmig gewunden ist und insbesondere einen kreisförmigem Querschnitt aufweist. Alternativ wird als Grundelement anstelle eines Metalldrahts ein Metallstreifen verwendet, der einen von einem kreisförmigen Querschnitt abweichenden Querschnitt, beispielsweise einen quadratischen oder rechteckförmigen Querschnitt, aufweist. Durch die schraubenförmige Windung ergibt sich eine Axialelastizität der Schraubenfeder. Vorzugsweise ist die Schraubenfeder außerdem derart ausgebildet, dass sie radialelastisch ist. Besonders bevorzugt ist die Schraubenfeder dazu zur Längsachse geneigt, also schräggewunden ausgebildet.

Bevorzugt ist die Radialvertiefung in einer Mantelaußenwand des Kolbens ausgebildet oder in einer Mantelinnenwand einer an einer freien Stirnseite des Kolbens ausgebildeten Axialvertiefung. Damit eignet sich der Prüfstift entweder dazu, in eine Aufnahmeöffnung eines Kontaktpartners zu dessen elektrischer Kontaktierung eingeschoben zu werden, oder auf einen stiftförmigen Kontaktpartner aufgeschoben zu werden. In beiden Fällen wird jeweils durch die Schraubenfeder der sichere elektrische Berührungskontakt gewährleistet.

Weiterhin ist bevorzugt vorgesehen, dass sich die Schraubenfeder gradlinig oder gekrümmt, insbesondere quer zur Längserstreckung des Prüfstifts oder Kolbens erstreckt. Für den Fall, dass die Schraubenfeder sich gekrümmt quer zur Längserstreckung des Kolbens erstreckt, entspricht die Krümmung bevorzugt dem Radius der Schraubenfeder zu einer Längsmittelachse des Kolbens. In dem Fall ist die Axialvertiefung bevorzugt zylinderförmig, insbesondere kreiszylinderförmig, ausgebildet.

Grundsätzlich ist der Kolben bevorzugt zylinderförmig ausgebildet, wobei die Zylinderform im Querschnitt eckig, insbesondere rechteckig, oder rund, insbesondere kreisrund, sein kann. Erstreckt sich die Schraubenfeder gradlinig, so kann sie sich nicht über den Umfang des Kontaktpartners erstrecken, sondern erstreckt sich nur entlang eines Kontaktbereichs. In diesem Fall sind dann bevorzugt mehrere gradlinige Schraubenfedern vorhanden, um an mehreren Seiten des Kolbens einen elektrischen Berührungskontakt zu dem Kontaktpartner zu gewährleisten.

Gemäß einer bevorzugten Ausführungsform der Erfindung ist die Schraubenfeder, wie vorstehend bereits erwähnt, als Schrägwindungsfeder, also schräggewunden ausgebildet. Dadurch ergibt sich insbesondere die vorteilhafte Radialelastizität, die ein Einfedern der Schraubenfeder radial nach außen oder innen - von einer Längsmittelachse des Kolbens aus gehen - zur sicheren Berührungskontaktierung des Kontaktpartners erlaubt.

Besonders bevorzugt weist der elektrisch leitfähig ausgebildete Kolben an einer freien Stirnseite eine beispielsweise zylinderförmige Axialvertiefung für den Kontaktpartner auf, wobei eine Mantelinnenwand der Axialvertiefung zumindest eine Radialvertiefung aufweist, in welcher zumindest eine sich beispielsweise ringförmig erstreckende, insbesondere kreisringförmige Schraubenfeder angeordnet ist, die die Mantelinnenwand radial nach innen überragt beziehungsweise von dieser nach innen vorsteht. Die Axialvertiefung dient zur bereichsweisen Aufnahme des Kontaktpartners, der insbesondere axial in diese eingeschoben wird beziehungsweise einschiebbar ist, und ist bevorzugt an die Außenkontur des Kontaktpartners angepasst. Die Außenkontur der Axialvertiefung wird durch die Mantelinnenwand definiert. In dieser Mantelinnenwand ist nun die zumindest eine Radialvertiefung ausgebildet, die sich also von der axial erstreckenden Axialvertiefung radial nach außen in den Kolben hinein erstreckt. Dieser Radialvertiefung ist nun zumindest eine sich insbesondere ringförmig erstreckende Schraubenfeder angeordnet. Schraubenfedern weisen üblicherweise, in einer axialen Draufsicht gesehen, eine kreisringförmige Kontur auf. Erstreckt sich eine Schraubenfeder ringförmig, so bedeutet dies, dass sich die Schraubenfeder in ihrer Längserstreckung ringförmig erstreckt, also in ihrer Längserstreckung gekrümmt ist, sodass sich eine geschlossene oder offene Ringform ergibt. Dazu kann die Schraubenfeder insgesamt gekrümmt sein, um eine ovale oder kreisförmige Schraubenfeder zu erhalten, oder abschnittsweise, um eine Schraubenfeder zu erhalten, die sich abschnittsweise geradlinig und abschnittsweise gekrümmt erstreckt, um eine Ringform zu bilden. Durch die elastische Verformbarkeit der Schraubenfeder weicht diese durch elastische Verformung radial nach außen aus, sobald ein Kontaktpartner in die Axialvertiefung eingeschoben wird, dessen Außenkontur oder Durchmesser größer ist, als der Innendurchmesser oder die Innenkontur der Schraubenfeder. Die Schraubenfeder wird dadurch beim Einschieben des Kontaktpartners vorgespannt, sodass sie sicher an der Mantelaußenwand des Kontaktpartners anliegt und den gewünschten Berührungskontakt gewährleistet.

Gemäß einer bevorzugten Ausführungsform der Erfindung ist die sich ringförmig erstreckende Schraubenfeder koaxial zur Axialvertiefung angeordnet. Damit erstreckt sich die Schraubenfeder in ihrer ringförmigen Längserstreckung koaxial zur Axialvertiefung, sodass sie den Kontaktpartner entlang seines Umfangs an mehreren Stellen berührungskontaktiert, wobei sich die Anzahl der Berührungskontaktstellen insbesondere aus der Anzahl der Windungen der Schraubenfeder entlang ihrer Längserstreckung ergibt.

Weiterhin ist bevorzugt vorgesehen, dass mehrere sich insbesondere ringförmig erstreckende Schraubenfedern in einer oder jeweils einer Radialvertiefung wie vorstehend beschrieben angeordnet sind. Dadurch wird die Berührungskontaktfläche zu dem Kontaktpartner mit der Anzahl der Schraubenfedern auch bei gleichbleibender Windungszahl jeder Schraubenfeder erhöht. Sind die Schraubenfedern in jeweils einer Radialvertiefung angeordnet, so ist jede Schraubenfeder für sich genommen gestützt in dem Kolben angeordnet. Sind mehrere Schraubenfedern in einer gemeinsamen Radialvertiefung angeordnet, so stützen sie sich zum Teil auch gegenseitig axial ab. Die elastische Verformbarkeit der Schraubenfedern, insbesondere in radialer Richtung, sorgt für eine hohe Kontaktsicherheit, weil Maß- und Formtoleranzen, beispielsweise Unebenheiten, auf den Berührungsflächen sowohl des Kontaktpartners als auch des Prüfstifts ausgeglichen werden.

Bevorzugt sind die mehreren Schraubenfedern axial beabstandet zueinander angeordnet. Dazu sind die Schraubenfedern zweckmäßigerweise in jeweils einer Radialvertiefung eingesetzt. Durch einen axialen Abstand wird erreicht, dass die Schraubenfeder beim Ein- oder Ausschieben des Kontaktpartners nicht seitlich aneinander geraten und dadurch beispielsweise miteinander verhaken oder verklemmen können. Durch die beabstandete Anordnung wird eine verbesserte Wärmeableitung sowie eine verbesserte Kraftverteilung und eine Reaktion gegenseitiger Abnutzung der Schraubenfedern selbst erreicht. Alternativ sind nebeneinanderliegende Schraubenfedern bevorzugt mit gegenläufiger Verkantungsrichtung in einer gemeinsamenRadialvertiefung angeordnet, sodass sich die Schraubenfedern bei Auftreten einer axialen Last oder Kraftbeanspruchung ineinander schieben, sodass sich Windungen der Schraubenfedern überlappen.

Alternativ ist bevorzugt vorgesehen, dass die mehreren sich ringförmig erstreckenden Schraubenfedern in Umfangsrichtung des Kolbens gesehen hintereinanderliegend angeordnet sind und jeweils bereichsweise über die Mantelinnenwand radial nach innen vorstehen. In dieser Ausführungsform sind die Schraubenfedern also nicht koaxial zu der Aufnahmevertiefung beziehungsweise der Axialvertiefung angeordnet, sodass sie mit ihrer Innenseite den Kontaktpartner kontaktieren, sondern derart über den Umfang des Kolbens gesehen verteilt angeordnet, dass sie mit ihrer Außenseite der Ringform den Kontaktpartner kontaktieren. Dadurch wird der Federweg der jeweiligen Schraubenfeder erhöht und ein geringer Druck auf den Kontaktpartner ausgeübt, wodurch beispielsweise Schädigungen durch Kratzer oder dergleichen leichter vermieden werden können. Alternativ sind die mehreren sich ringförmig erstreckenden Schraubenfedern derart an dem Kolben angeordnet, dass sie über die Mantelaußenwand radial nach außen vorstehen, wie vorstehend bereits erwähnt. Besonders bevorzugt ist zumindest eine sich ringförmig erstreckende Schraubenfeder vorzugsweise auf ein Oval in der Radialvertiefung vorgespannt beziehungsweise gekrümmt, wobei der größte Krümmungsradius dem Kontaktpartner zugewandt ist. Damit ergibt sich eine größere Berührungsfläche mit vielen Windungen und der Außendurchmesser nicht ab.

Gemäß einer bevorzugten Weiterbildung der Erfindung sind die mehreren Schraubenfedern dabei gleichmäßig über den Umfang des Kolbens verteilt angeordnet, um eine gleichmäßige Kraftbeaufschlagung des Kontaktpartners zu gewährleisten.

Weiterhin weist die Radialvertiefung bevorzugt einen C-förmigen Querschnitt zum Hintergreifen der Schraubenfedern auf. Dadurch wird erreicht, dass die Schraubenfedern in der Radialvertiefung formschlüssig gehalten sind und nicht ohne weiteres aus diesem entfernt werden können. Insbesondere ist die freibleibende Aussparung oder Öffnung der Radialvertiefung kleiner als der Außendurchmesser der Schraubenfedern gewählt, sodass diese einfach durch elastische Verformung einsetzbar sind und ein ungewolltes Herausfallen sicher verhindert ist.

Weiterhin ist zumindest eine Schraubenfeder bevorzugt schraubenfederförmig oder gewindeförmig entlang der Axialvertiefung erstreckend ausgebildet. Diese Schraubenfeder erstreckt sich damit in ihrer Längserstreckung schraubenfederförmig oder gewindeförmig entlang der Axialvertiefung, sodass sie an mehreren axialen Abschnitten den Kontaktpartner gleichmäßig, axial und radial, über die Oberfläche verteilt berührungskontaktiert.

Weiterhin ist bevorzugt vorgesehen, dass der Kolben in einer Führungshülse axial verschiebbar gelagert ist. Hierdurch ergibt sich die vorstehend bereits beschriebene Möglichkeit, dass der Kolben zurückfedern kann, falls der Anpressdruck des Kontaktpartners derart groß ist, dass eine Beschädigung des Prüfstifts oder des Kontaktpartners befürchtet werden muss.

Insbesondere ist dazu zwischen dem Kolben und der Führungshülse zumindest ein Federelement, insbesondere eine sich axial erstreckende Schraubenfeder, vorgespannt gehalten, welche Kolben und Führungshülse auseinanderdrängt. Zweckmäßigerweise wirkt dabei zwischen Kolben und Führungshülse ein Heizelement, das die maximale Bewegung des Kolbens zur Führungshülse formschlüssig begrenzt, um ein unerwünschtes Herausschieben des Kolbens aus der Führungshülse durch das Federelement zu verhindern. Ist die Einpresskraft des Kontaktpartners größer als die Druckkraft des Federelements, federt letzteres ein und der Kolben weicht beziehungsweise federt zurück, sodass eine Beschädigung von Prüfstift und/oder Kontaktpartner verhindert wird. Hierzu ist bevorzugt die Axialkraft des Federelements geringfügig größer gewählt oder dimensioniert als die erwartete Gleitreibung zwischen Kontaktpartner und Prüfstift beim Einstecken oder Aufstecken des Prüfstifts in oder auf den Kontaktpartner. Der freie Federweg des Kolbens in der Führungshülse entspricht bevorzugt zumindest der maximalen Einstecktiefe oder Aufstecktiefe des Kontaktpartners. Optional ist der Prüfstift als Schaltstift ausgebildet, der in Abhängigkeit von der einen Federtiefe des Kolbens in die Führungshülse insbesondere einen elektrischen Kontakt herstellt oder löst, sodass in Abhängigkeit von dem Einfedern des Kolbens ein elektrisches Schalten realisierbar ist.

Im Folgenden soll die Erfindung anhand der Zeichnung näher erläutert werden. Dazu zeigen
- Figur 1: einen vorteilhaften Prüfstift mit innenliegenden Kontaktmitteln in einer perspektivischen Darstellung,
- Figuren 2A und 2B: den Prüfstift in einer Längsschnittdarstellung sowie in einer Draufsicht,
- Figur 3: ein weiteres Ausführungsbeispiel des Prüfstifts in einer perspektivischen Darstellung,
- Figur 4: ein weiteres Ausführungsbeispiel des Prüfstifts in einer Seitenansicht,
- Figur 5: ein weiteres Ausführungsbeispiel des Prüfstifts mit innenliegenden Kontaktmitteln in einer Längsschnittdarstellung,
- Figur 6: ein weiteres Ausführungsbeispiel des Prüfstifts mit innenliegenden Kontaktmitteln in einer perspektivischen Darstellung und
- Figur 7: ein Ausführungsbeispiel des Prüfstifts mit außenliegenden Kontaktmitteln.

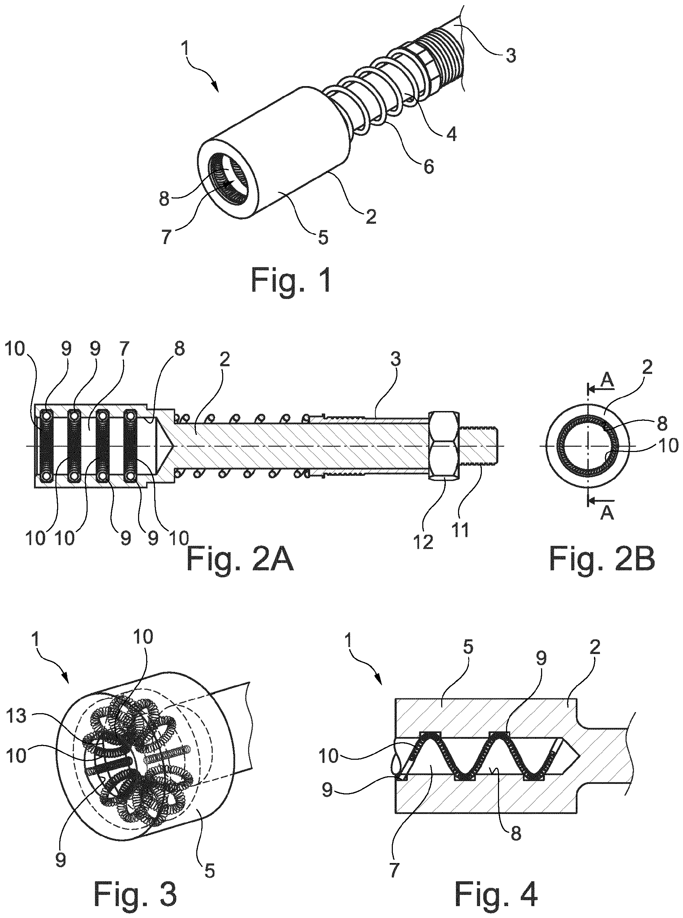

Figur 1 zeigt in einer perspektivischen Darstellung einen vorteilhaften Prüfstift 1, der beispielsweise in einem hier nicht dargestellten Kontaktkopf einer Prüfeinrichtung, die insbesondere mehrere derartiger Prüfstifte 1 aufweist, gehalten ist, um einen, insbesondere mehrere Kontaktpartner elektrisch, beispielsweise zur Durchführung elektrischer Tests zu kontaktieren. Der Prüfstift 1 weist dazu einen Kolben 2 auf, der in einer Führungshülse 3 längsverschieblich gelagert ist. Dazu weist der Kolben 2 einen Abschnitt 4 auf, dessen Außendurchmesser kleiner ist als der Innendurchmesser der Führungshülse 3. An seinem freien Ende weist der Kolben 2 einen Abschnitt 5 auf, dessen Durchmesser größer ist als der Durchmesser der Führungshülse 3, sodass der Kolben 2 maximal bis zu dem Abschnitt 5 in die Führungshülse 3 einschiebbar ist. Zwischen der Führungshülse 3 und dem Abschnitt 5 ist außerdem axial eine Schraubenfeder 6 vorgespannt, die koaxial zu dem Abschnitt 4 des Kolbens 2 angeordnet ist. Der Kolben 2 kann somit entgegen der Kraft der Schraubenfeder 6 in die Führungshülse 3 hineinfedern, sofern die Federkraft der Schraubenfeder 6 überwunden wird. Bei dem Prüfstift 1 handelt es sich somit um einen einpoligen oder einkanaligen Prüfstift 1, der dazu ausgebildet ist, nur eine einzige elektrische Verbindung zwischen dem Prüfling und der Prüfeinrichtung herzustellen. Der Prüfstift 1 weist somit nur einen einzigen elektrischen Leiterweg beziehungsweise Leitungsweg zur elektrischen Verbindung des Prüflings mit der Prüfeinrichtung auf.

Der Kolben 2 weist an seinem freien Ende an dem Abschnitt 5 außerdem stirnseitig eine Axialvertiefung 7 auf, die vorliegend kreiszylinderförmig ausgebildet und koaxial zu dem Kolben 2 ausgerichtet ist.

Zum besseren Verständnis zeigt Figur 2A den Prüfstift 1 in einer vereinfachten Längsschnittdarstellung.

Die Axialvertiefung 7 erstreckt sich nahezu durch den gesamten Abschnitt 5 des Kolbens 2. Dabei weist die Axialvertiefung 7 einen im Wesentlichen konstanten Durchmesser auf, wobei in der Mantelinnenwand 8 der Axialvertiefung 7 mehrere Radialvertiefungen 9 ausgebildet sind. Die Radialvertiefungen 9 sind dabei jeweils als Umfangsnut, also als sich über den gesamten Umfang der Mantelinnenwand 8 erstreckenden Nut ausgebildet, wobei benachbarte Radialvertiefungen 9 axial beabstandet und parallel zueinander ausgebildet sind.

In jeder der Radialvertiefungen 9 liegt eine sich kreisringförmig erstreckende Schraubenfeder 10 ein. Die Schraubenfedern 10 folgen somit dem kreis- beziehungsweise ringförmigen Verlauf der Radialvertiefung 9 und bilden dadurch selbst eine Ringform. Die Schraubenfedern 10 können dabei an ihren freien Enden miteinander insbesondere stoffschlüssig verbunden sein, um einen geschlossenen Ring zu bilden, oder freie Enden aufweisen. Die Schraubenfedern 10 sind dabei derart ausgebildet, dass der Windungsdurchmesser größer als die Tiefe der Radialvertiefungen 9, sodass die Schraubenfedern 10 innen über die Mantelinnenwand 8 hinaus vorstehen. Der Innendurchmesser der ringförmigen Schraubenfeder 10 ist somit kleiner als der Innendurchmesser der Axialvertiefung 7.

Dies ist auch in Figur 2B ersichtlich, die eine Draufsicht auf das freie Ende des Kolbens 2 zeigt. Wird nun ein stiftförmiger Kontaktpartner (gestrichelt gezeigt) in die Axialvertiefung 7 eingeführt, dessen Außendurchmesser größer ist als der Innendurchmesser der Schraubenfedern 10, so beaufschlagt der Kontaktpartner die Schraubenfedern 10 mit einer Kraft, durch welche die Schraubenfedern 10 elastisch verformt werden, insbesondere derart weit, dass der Kontaktpartner in die Aufnahmevertiefung 7 an den Schraubenfedern 10 vorbeischiebbar ist. Dabei werden die Schraubenfedern 10 beispielsweise, wie in Figur 2B gezeigt, derart verformt, dass sich der Innenabschnitt zum Außenabschnitt in Umfangsrichtung gesehen verschiebt. Dadurch entsteht eine auf den Kontaktpartner wirkende Vorspannung, durch welche die Schraubenfedern 10 sicher auf der Mantelaußenfläche des Kontaktpartners aufliegen. Bevorzugt sind die Schraubenfedern 10 als schräggewickelte beziehungsweise -gewundene Schraubenfedern ausgebildet, deren Windungen schräg zu einer Senkrechten zur Längserstreckung ausgerichtet sind, wie in Figur 2B gezeigt, sodass die Verschiebung des Innenabschnitts zum Außenabschnitt der jeweiligen Schraubenfeder 10 bereits im unbelasteten Zustand besteht. Dadurch wird insbesondere eine Radialelastizität der Schraubenfeder 10 gewährleistet und das Einschieben eines Kontaktpartners und das dadurch erfolgende Verformen der jeweiligen Schraubenfeder 10 zur elektrischen Berührungskontaktierung vereinfacht. In dem vorliegenden Ausführungsbeispiel von Figuren 1 und 2 sind die Schraubenfedern 10 als derartige schräggewickelte Schraubenfedern ausgebildet.

Der Kolben 2 und die Schraubenfedern 10 sind zweckmäßigerweise aus einem elektrisch leitfähigen Material gefertigt, sodass durch das Einschieben des Kontaktpartners in die Axialvertiefung 7 durch die Schraubenfedern 10 eine sichere Berührungskontaktierung und damit eine sichere elektrische Kontaktierung des Kontaktpartners durch den Prüfstift 1, der insoweit als einpoliger Prüfstift ausgebildet ist, erfolgt. Anschließend kann beispielsweise mittels des Prüfstifts 1 ein Strom gemessen oder der Kontaktpartner mit einem Strom oder einer elektrischen Spannung beaufschlagt werden, um beispielsweise einen Test durchzuführen. Nach Abschluss des Testvorgangs ist der Kontaktpartner einfach aus der Axialvertiefung 7 wieder herausziehbar, wobei sich nach dem Entfernen des Kontaktpartners die Schraubenfedern 10 wieder entspannen und in ihre Ausgangsposition zurückgelangen.

Ist die Einpresskraft besonders hoch, weil der Außendurchmesser des Kontaktpartners beispielsweise größer als erwartet ist, kann der Kolben 2 entgegen der Kraft der Schraubenfeder 6 zurück in die Führungshülse 3, wie zuvor beschrieben, einfedern. Damit sich der Kolben 2 nicht ungewollt von der Führungshülse löst, weist er an seinem von dem Abschnitt 5 abgewandten Ende ein Schraubgewinde 11 auf, auf welches eine Schraubenmutter 12 aufgeschraubt ist, deren Durchmesser größer ist als der Durchmesser der Führungshülse 3, sodass der Kolben 2 zwischen dem Abschnitt 5 und der Schraubenmutter 12 an der Führungshülse 3 gefangen ist. Selbstverständlich können auch andere Befestigungsmittel anstelle von Schraubgewinde 11 und Schraubenmutter 12 vorgesehen sein.

Figur 3 zeigt ein weiteres Ausführungsbeispiel des Prüfstifts 1 in einer perspektivischen Darstellung, das sich von dem vorhergehenden Ausführungsbeispiel dadurch unterscheidet, dass in dem Abschnitt 5 nur eine Radialvertiefung 9 ausgebildet ist, in welcher jedoch eine Vielzahl von Schraubenfedern 10 angeordnet sind. Im Unterschied zum vorhergehenden Ausführungsbeispiel sind die Schraubenfedern 10 dabei nicht koaxial zur Aufnahmevertiefung 7 ausgerichtet, sondern in Umfangsrichtung des Kolbens 2 gesehen hintereinanderliegend, sodass die zentralen Mittelachsen der jeweiligen Ringform der Schraubenfedern 10 tangential ausgerichtet sind. Vorzugsweise sind auch in diesem Ausführungsbeispiel die Schraubenfedern 10 als Schrägwindungsfedern ausgebildet. Die Schraubenfedern 10 liegen dabei nahezu vollständig in der Radialvertiefung 9 ein, wie bevorzugt C-förmig ausgebildet ist, sodass die Öffnung 13 der Radialvertiefung 9 kleiner als der Außendurchmesser der Schraubenfedern 10, sodass diese nicht aus der jeweiligen Radialvertiefung 9 herausfallen können. Optional sind zwischen benachbarten Schraubenfedern 10 Haltemittel vorhanden, welche verhindern, dass die Schraubenfedern 10 zur Seite kippen oder miteinander verklemmen oder verhaken. Alternativ ist für jede Schraubenfeder 10 eine eigene Radialvertiefung ausgebildet, die im Unterschied zum vorhergehenden Ausführungsbeispiel nicht koaxial zur Aufnahmevertiefung 7 als Umfangsnut ausgebildet ist, sondern als radiale Seitentasche, in welche jeweils eine Schraubenfeder 10 bereichsweise einliegt, sodass zumindest ein Abschnitt der jeweiligen Schraubenfeder über die Mantelinnenwand 8 hinaus in die Aufnahmevertiefung 7 vorsteht, um dort mit dem Kontaktpartner, wie zuvor beschrieben, zusammenzuwirken.

Figur 4 zeigt ein weiteres Ausführungsbeispiel, das sich von dem ersten Ausführungsbeispiel dadurch unterscheidet, dass sich die Radialvertiefung 9 nicht als Umfangsnut ausgebildet ist, sondern als schraubenförmige Nut oder Gewindenut, die sich axial entlang der Aufnahmevertiefung 7 erstreckt, sodass die darin einliegende Schraubenfeder 10 in der Draufsicht ringförmig ausgebildet ist, in einer Seitenansicht, wie sie in Figur 4 gezeigt ist, jedoch gewinde- oder schraubenförmig. Vorzugsweise ist auch hier die Schraubenfeder 10 als Schrägwindungsfeder ausgebildet.

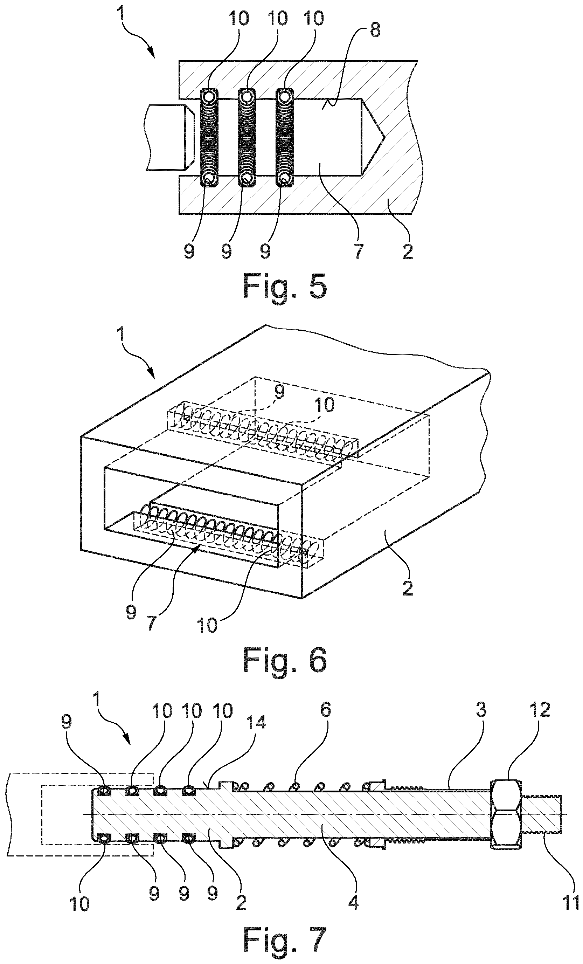

Figur 5 zeigt in einer vereinfachten Längsschnittdarstellung ein weiteres Ausführungsbeispiel, das eine Weiterbildung des in Figur 2A gezeigten Ausführungsbeispiels darstellt. Während in dem Ausführungsbeispiel von Figur 2A die Schraubenfedern 10 koaxial und koradial zueinander angeordnet sind, ist gemäß dem Ausführungsbeispiel von Figur 5 vorgesehen, dass sich die Durchmesser der sich ringförmig erstreckenden Schraubenfedern 10, insbesondere Schrägwindungsfedern, voneinander unterscheiden. Dabei ist vorliegend vorgesehen, dass in Einsteckrichtung eines Kontaktpartners in die Axialvertiefung 7 die Durchmesser der Schraubenfedern 10 abnehmen, sodass mit der letzten Schraubenfeder 10, die mit dem Kontaktpartner in Kontakt gelangt, die höchste Anpresskraft erreicht wird. Durch die unterschiedlichen Durchmesser sind auch die Kontaktkräfte und die axialen Steckkräfte unterschiedlich, sodass mit der ersten den Kontaktpartner erreichenden Schraubenfeder 10 eine kleinere Kontaktkraft und damit ein kleinerer Verschleiß erzeugt wird, wie mit den später folgenden Schraubenfedern 10. Weil die vorderen Schraubenfedern 10 jedoch axial weiter über den Kontaktpartner schleifen als die hinteren, ergibt sich dadurch eine vorteilhafte gleichmäßige Verschleißverteilung über die Kontaktlänge des Kontaktpartners.

Figur 6 zeigt ein weiteres Ausführungsbeispiel des Prüfstifts 1 mit innenliegenden Kontaktmitteln, wobei sich dieses Ausführungsbeispiel von den vorhergehenden Ausführungsbeispielen dadurch unterscheidet, dass der Kolben 2 keinen kreiszylinderförmigen Querschnitt aufweist, sondern einen rechteckigen. Damit weist auch die Axialvertiefung 7 einen rechteckigen Querschnitt auf. Anstatt, dass die Schraubenfedern 10 wie in den bisherigen Ausführungsbeispielen sich gekrümmt oder ringförmig erstrecken, ist nunmehr vorgesehen, dass sie sich nun geradlinig parallel zu einer der Seitenflächen des Kolbens beziehungsweise der Mantelinnenwand der Axialvertiefung 7 erstrecken. Gemäß dem vorliegenden Ausführungsbeispiel von Figur 6 sind zwei Schraubenfedern 10 vorhanden, die in jeweils einer Radialvertiefung 9 einliegen, wobei die Radialvertiefungen auf zwei gegenüberliegenden Seiten der Axialvertiefung 7 angeordnet und parallel zueinander ausgerichtet sind, sodass sich die beiden Schraubenfedern 10 gegenüberliegen. Die Schraubenfedern 10 sind dabei ebenfalls als schräggewickelte Schraubenfedern 10 beziehungsweise Schrägwindungsfedern ausgebildet, sodass beim Eindringen eines Kontaktpartners in die Axialvertiefung 7 eine elastische Verformung der Schraubenfedern 10 sicher erfolgt und dadurch eine Kontaktkraft auf den Kontaktpartner durch die Schraubenfedern 10 als Kontaktmittel ausgeübt wird, wodurch eine sichere Kontaktierung mit geringem Verschleiß erreicht ist. Optional sind auch hierbei mehrere Schraubenfedern 10 in Einsteckrichtung hintereinanderliegend in der Axialvertiefung 7 vorhanden. Insbesondere sind mehrere Schraubenfederpaare, wie sie in Figur 6 gezeigt sind, in Einsteckrichtung des Kontaktpartners vorgesehen.

Die vorstehend beschriebenen Ausrichtungen, Anordnungen und Ausbildungen der Schraubenfedern 10 sind auch bei einem Prüfstift 1 anwendbar, bei welchem die Schraubenfedern 10 auf einer Mantelaußenwand 14 des Kolbens 2 angeordnet sind.

Figur 7 zeigt hierzu ein weiteres Ausführungsbeispiel des Prüfstifts 1, wobei gemäß diesem Ausführungsbeispiel die Kontaktmittel nicht an einer Mantelinnenwand einer Axialvertiefung des Prüfstifts ausgebildet sind, sondern an einer Mantelaußenwand 14. Dazu sind die Radialvertiefungen 9 in der Mantelaußenwand 14 des freien Endes des Kolbens 2 angeordnet. Vorzugsweise sind die Schraubenfedern 10 auch hier als Schrägwindungsfedern beziehungsweise als schräggewickelte Schraubenfedern ausgebildet. Die Radialvertiefungen 9 erstrecken sich über den Außenumfang des Kolbens 2, wobei sich auch die Schraubenfedern 10 ringförmig über den Außenumfang beziehungsweise die Außenmantelwand 14 des Kolbens 2 in den Radialvertiefungen einliegend erstrecken.

Damit eignet sich dieser Prüfstift 1 dazu, in eine Aufnahmeöffnung eines Kontaktpartners eingesteckt zu werden. In Figur 7 ist dazu ein Kontaktpartner mit einem hülsenförmigen Kontaktabschnitt gestrichelt dargestellt. Auch hier wird eine vorteilhafte Vorspannung erreicht, die eine sichere Berührungskontaktierung des Kontaktpartners, wie vorstehend beschrieben, erlaubt.

Grundsätzlich gilt, dass die Anzahl der Schraubenfedern 10 variierbar ist. Gemäß einem weiteren Ausführungsbeispiel weist der Prüfstift 1 nur eine Schraubenfeder 10 auf, die an der Mantelinnenwand 8 oder Mantelaußenwand 14 radial vorstehend angeordnet ist. Auch kann der Prüfstift 1 nur zwei oder mehr als drei Schraubenfedern 10, die insbesondere als Schrägwindungsfedern ausgebildet sind, aufweisen.

## Patentansprüche

1. Einpoliger Prüfstift (1) zum lösbaren Kontaktieren eines elektrisch leitfähigen und stiftförmig ausgebildeten Kontaktpartners, wobei der Prüfstift (1) dazu ausgebildet ist, nur eine einzige elektrische Verbindung von dem Kontaktpartner zu einer Prüfeinrichtung herzustellen, mit einem in einer Führungshülse (3) längsverschieblich lagerbaren Kolben (2), der an einem freien Ende Mittel zum elektrisch leitenden Berührungskontaktieren des Kontaktpartners aufweist, **dadurch gekennzeichnet, dass** eine Mantelwand (8,14) des elektrisch leitfähig ausgebildeten Kolbens (2) an seinem freien Ende zumindest eine Radialvertiefung (9) aufweist, in welcher zumindest eine Schraubenfeder (10) als Mittel zum elektrisch leitenden Berührungskontaktieren des Kontaktpartners angeordnet ist, die sich quer zur Längserstreckung des Kolbens (2) erstreckt und von der Mantelwand (8,14) radial vorsteht.

2. Prüfstift nach Anspruch 1, **dadurch gekennzeichnet, dass** die Radialvertiefung (9) in einer Mantelaußenwand (14) des Kolbens (2) oder in einer Mantelinnenwand (8) einer an einer freien Stirnseite des Kolbens (2) ausgebildeten Axialvertiefung (7) ausgebildet.

3. Prüfstift nach einem der vorhergehenden Ansprüche, **dadurch gekennzeichnet, dass** sich die Schraubenfeder (10) gradlinig oder gekrümmt erstreckt.

4. Prüfstift nach einem der vorhergehenden Ansprüche, **dadurch gekennzeichnet, dass** sich die Schraubenfeder (10) ringförmig erstreckt und koaxial zur Mantelwand (8,14) angeordnet ist.

5. Prüfstift nach einem der vorhergehenden Ansprüche, **dadurch gekennzeichnet, dass** sich die Schraubenfeder (10) ringförmig über den Umfang, insbesondere über den gesamten Umfang des Kolbens (2) erstreckt.

6. Prüfstift nach einem der vorhergehenden Ansprüche, **dadurch gekennzeichnet, dass** der Kolben (2) einen runden, insbesondere kreisrunden Querschnitt oder einen eckigen, insbesondere viereckigen Querschnitt aufweist.

7. Prüfstift nach einem der vorhergehenden Ansprüche, **dadurch gekennzeichnet, dass** die jeweilige Schraubenfeder (10) als Schrägwindungsfeder ausgebildet ist.

8. Prüfstift nach einem der vorhergehenden Ansprüche, **dadurch gekennzeichnet, dass** mehrere, insbesondere sich ringförmig erstreckende Schraubenfedern (10) in einer oder jeweils einer Radialvertiefung (9) angeordnet sind.

9. Prüfstift nach einem der vorhergehenden Ansprüche, **dadurch gekennzeichnet, dass** die mehreren Schraubenfedern (10) axial beabstandet zueinander angeordnet sind.

10. Prüfstift nach einem der vorhergehenden Ansprüche, **dadurch gekennzeichnet, dass** mehrere Schraubenfedern (10) in Umfangsrichtung des Kolbens (2) gesehen hintereinanderliegend angeordnet sind und jeweils bereichsweise über die Mantelinnenwand (8) radial nach innen oder über die Mantelaußenwand (14) des Kolbens (2) radial nach außen vorstehen.

11. Prüfstift nach einem der vorhergehenden Ansprüche, **dadurch gekennzeichnet, dass** mehrere Schraubenfedern (10) gleichmäßig über den Umfang des Kolbens (2) verteilt angeordnet sind.

12. Prüfstift nach einem der vorhergehenden Ansprüche, **dadurch gekennzeichnet, dass** die Radialvertiefung (9) einen C-förmigen Querschnitt zum Hintergreifen der Schraubenfedern (10) aufweist.

13. Prüfstift nach einem der vorhergehenden Ansprüche, **dadurch gekennzeichnet, dass** sich zumindest eine Schraubenfeder (10) schraubenfederförmig oder gewindeförmig entlang der Axialvertiefung erstreckt.

14. Prüfstift nach einem der vorhergehenden Ansprüche, **dadurch gekennzeichnet, dass** der Kolben (2) in einer Führungshülse (3) axial verschiebbar gelagert ist.

15. Prüfstift nach einem der vorhergehenden Ansprüche, **dadurch gekennzeichnet, dass** zwischen dem Kolben (2) und der Führungshülse (3) zumindest ein Federelement, insbesondere eine sich axial erstreckende Schraubenfeder (6), vorgespannt oder vorspannbar gehalten ist.

16. Prüfstift nach einem der vorhergehenden Ansprüche, **dadurch gekennzeichnet, dass** zumindest zwei der Schraubenfedern (10) unterschiedlich weit von der Mantelwand des Kolbens (2) radial vorstehen.

## Claims

1. Single-pole test pin (1) for detachably contacting an electrically conductive and pin-shaped contact partner, wherein the test pin (1) is configured to establish only a single electrical connection from the contact partner to a test device, said test pin comprising a piston (2) which is longitudinally displaceably mountable in a guide sleeve (3) and has means for electrically conductive contacting of the contact partner at a free end, **characterized in that** a circumferential wall (8, 14) of the electrically conductive piston (2) has at least one radial recess (9) at its free end, in which at least one helical spring (10) is arranged as a means for electrically conductive contacting of the contact partner, which extends transversely to the longitudinal extent of the piston (2) and projects radially from the circumferential wall (8, 14).

2. Test pin according to claim 1, **characterized in that** the radial recess (9) is formed in a circumferential outer wall (14) of the piston (2) or in a circumferential inner wall (8) of an axial recess (7) formed on a free end face of the piston (2).

3. Test pin according to one of the preceding claims, **characterized in that** the helical spring (10) extends in a straight line or curved.

4. Test pin according to one of the preceding claims, **characterized in that** the helical spring (10) extends annularly and is arranged coaxially to the circumferential wall (8, 14).

5. Test pin according to one of the preceding claims, **characterized in that** the helical spring (10) extends annularly over the circumference, in particular over the entire circumference, of the piston (2).

6. Test pin according to one of the preceding claims, **characterized in that** the piston (2) has a round, in particular circular, cross-section or an angular, in particular square, cross-section.

7. Test pin according to one of the preceding claims, **characterized in that** the respective helical spring (10) is designed as an inclined coil spring.

8. Test pin according to one of the preceding claims, **characterized in that** a plurality of helical springs (10), in particular extending annularly, are arranged in one or in each case one radial recess (9).

9. Test pin according to one of the preceding claims, **characterized in that** the several helical springs (10) are arranged axially spaced apart.

10. Test pin according to one of the preceding claims, **characterized in that** a plurality of helical springs (10) are arranged one behind the other as seen in the circumferential direction of the piston (2) and in each case project radially inwards over the circumferential inner wall (8) or radially outwards over the circumferential outer wall (14) of the piston (2) in certain regions.

11. Test pin according to one of the preceding claims, **characterized in that** a plurality of helical springs (10) are arranged uniformly distributed over the circumference of the piston (2).

12. Test pin according to one of the preceding claims, **characterized in that** the radial recess (9) has a C-shaped cross-section for gripping behind the helical springs (10).

13. Test pin according to one of the preceding claims, **characterized in that** at least one helical spring (10) extends along the axial recess in the shape of a helical spring or thread.

14. Test pin according to one of the preceding claims, **characterized in that** the piston (2) is mounted axially displaceable in a guide sleeve (3).

15. Test pin according to one of the preceding claims, **characterized in that** at least one spring element, in particular an axially extending helical spring (6), is held between the piston (2) and the guide sleeve (3) in a prestressed or prestressable manner.

16. Test pin according to one of the preceding claims, **characterized in that** at least two of the helical springs (10) radially project at different extents from the circumferential wall of the piston (2).

## Revendications

1. Broche de test unipolaire (1) pour la mise en contact amovible d'un partenaire de contact électriquement conducteur et en forme de broche, la broche de test (1) étant conçue pour n'établir qu'une seule liaison électrique entre le partenaire de contact et un dispositif de test, avec un piston (2) pouvant être logé de manière mobile longitudinalement dans une douille de guidage (3), qui présente à une extrémité libre des moyens pour la mise en contact par contact électriquement conducteur du partenaire de contact, **caractérisé en ce qu'**une paroi d'enveloppe (8, 14) du piston (2) réalisé de manière électriquement conductrice présente à son extrémité libre au moins un renfoncement radial (9) dans lequel est disposé au moins un ressort hélicoïdal (10) comme moyen de mise en contact par contact électriquement conducteur du partenaire de contact, qui s'étend transversalement à l'extension longitudinale du piston (2) et fait saillie radialement de la paroi d'enveloppe (8, 14).

2. Broche de test selon la revendication 1, **caractérisée en ce que** le renfoncement radial (9) est formé dans une paroi d'enveloppe extérieure (14) du piston (2) ou dans une paroi d'enveloppe intérieure (8) d'un renfoncement axial (7) formé sur une face frontale libre du piston (2).

3. Broche de test selon l'une des revendications précédentes, **caractérisée en ce que** le ressort hélicoïdal (10) s'étend de manière rectiligne ou incurvée.

4. Broche de test selon l'une des revendications précédentes, **caractérisée en ce que** le ressort hélicoïdal (10) s'étend en forme d'anneau et est disposé coaxialement à la paroi d'enveloppe (8, 14).

5. Broche de test selon l'une des revendications précédentes, **caractérisée en ce que** le ressort hélicoïdal (10) s'étend en forme d'anneau sur la circonférence, en particulier sur toute la circonférence du piston (2).

6. Broche de test selon l'une des revendications précédentes, **caractérisée en ce que** le piston (2) présente une section transversale ronde, en particulier circulaire, ou une section transversale anguleuse, en particulier quadrangulaire.

7. Broche de test selon l'une des revendications précédentes, **caractérisée en ce que** le ressort hélicoïdal (10) respectif est conçu comme un ressort à spires inclinées.

8. Broche de test selon l'une des revendications précédentes, **caractérisée en ce que** plusieurs ressorts hélicoïdaux (10), s'étendant en particulier en forme d'anneau, sont disposés dans une ou respectivement une renfoncement radiale (9).

9. Broche de test selon l'une des revendications précédentes, **caractérisée en ce que** les plusieurs ressorts hélicoïdaux (10) sont disposés à une distance axiale les uns des autres.

10. Broche de test selon l'une des revendications précédentes, **caractérisée en ce que** plusieurs ressorts hélicoïdaux (10) sont disposés les uns derrière les autres, vus dans la direction circonférentielle du piston (2), et dépassent chacun par zones radialement vers l'intérieur au-delà de la paroi d'enveloppe intérieure (8) ou radialement vers l'extérieur au-delà de la paroi d'enveloppe extérieure (14) du piston (2).

11. Broche de test selon l'une des revendications précédentes, **caractérisée en ce que** plusieurs ressorts hélicoïdaux (10) sont répartis uniformément sur la circonférence du piston (2).

12. Broche de test selon l'une des revendications précédentes, **caractérisée en ce que** le renfoncement radial (9) présente une section transversale en forme de C pour s'engager derrière les ressorts hélicoïdaux (10).

13. Broche de test selon l'une des revendications précédentes, **caractérisée en ce qu'**au moins un ressort hélicoïdal (10) s'étend en forme de ressort hélicoïdal ou de filet le long du renfoncement axiale.

14. Broche de test selon l'une des revendications précédentes, **caractérisée en ce que** le piston (2) est logé de manière à pouvoir se déplacer axialement dans une douille de guidage (3).

15. Broche de test selon l'une des revendications précédentes, **caractérisée en ce qu'**au moins un élément de ressort, en particulier un ressort hélicoïdal (6) s'étendant axialement, est maintenu précontraint ou peut être précontraint entre le piston (2) et la douille de guidage (3).

16. Broche de test selon l'une des revendications précédentes, **caractérisée en ce qu'**au moins deux des ressorts hélicoïdaux (10) dépassent radialement à des distances différentes de la paroi d'enveloppe du piston (2).
